# EUROPEAN PATENT APPLICATION

(11) **EP 2 448 025 A1**
(43) Date of publication of application: **02.05.2012**
(21) Application number: 10792148.8
(22) Date of filing: 23.06.2010
(51) Int. Cl.: H01L 33/60, H01L 33/64

(54) **LIGHT-EMITTING DEVICE**

(30) Priority: 23.06.2009 JP 2009148577
(71) Applicant: Asahi Glass Company, Limited, Chiyoda-ku Tokyo 100-8405 (JP)
(72) Inventor: NAKAYAMA, Katsuyoshi, Tokyo 100-8405 (JP); OKADA, Toshihisa, Tokyo 100-8405 (JP); OSAKI, Yasuko, Tokyo 100-8405 (JP)
(74) Representative: Müller-Boré & Partner Patentanwälte
(86) International application number: PCT/JP2010/060685
(87) International publication number: WO 2010/150830

(57) **Abstract**

Provided is a light-emitting device which is provided with a conductor layer for light reflection having a high light reflectance and being less susceptible to deterioration of the reflectance due to corrosion, has an improved light extraction efficiency, and is excellent in the heat dissipating properties.

A light-emitting device comprising a ceramic substrate having a lower ceramic layer, a conductor layer for light reflection formed on a desired area of the lower ceramic layer surface and an upper ceramic layer formed so as to cover at least a part of the conductor layer for light reflection, and a light-emitting element disposed on the upper side of the upper ceramic layer of the ceramic substrate, **characterized in that** the upper ceramic layer has a thickness of from 5 to 100 µm. The light-emitting device wherein the upper ceramic layer is composed of a glass-ceramics comprising, as represented by mass%, from 40 to 60% of a glass component and from 40 to 60% of a ceramic filler component.

## Description

### TECHNICAL FIELD

The present invention relates to a light-emitting device useful for formation of illumination devices such as a light-emitting diode (hereinafter sometimes referred to as LED) device, a high brightness photodiode backlight, a light source related to displays, automobile illumination, decorative illumination, sign and advertisement illumination, and an information display, and a mounting substrate to be used therefor.

### BACKGROUND ART

In recent years, along with a tendency to high brightness and whitening of light-emitting devices such as LEDs, a light-emitting device employing a LED has been used for a backlight of a mobile phone, a large sized liquid crystal TV, etc. In order to apply a LED lamp to various applications, it becomes important to obtain a white emission.

As systems to realize a white emission by a LED lamp, the following systems may, for example, be mentioned i.e. a system of using three LED chips which emit blue, green and red colors, respectively, a system of combining a blue-emitting LED chip with a yellow or orange-emitting phosphor, a system of combining a blue-emitting LED with a phosphor exciting red and green by the emission, and a system of combining an ultraviolet-emitting LED chip with a blue, green and red-emitting three-color mixed phosphor. As the above-mentioned systems of combining a LED chip with a phosphor, a cannonball structure is known which is prepared by casting a clear resin such as an epoxy resin or silicone resin having a phosphor mixed thereto, followed by solidification to form a resin layer containing the phosphor. Further, a structure is known which is prepared by mounting a LED chip on a substrate having a circuit pattern formed on its main surface and further forming on this substrate a sealing portion made of a clear resin.

In such a LED lamp, a light reflection layer made of e.g. silver is formed on the substrate around the mounted LED chip. And, by such a light reflection layer, an emission from the LED chip radiated to the substrate side, or a fluorescence emitted under excitation from the phosphor, is reflected to the forward direction thereby to improve the light extraction efficiency.

However, silver is likely to be corroded, and if it is left to stand, a compound such as Ag₂S is likely to be formed, whereby the light reflectance tends to deteriorate. Therefore, it has been attempted to prevent such a deterioration of the reflectance by forming a resin sealing layer on the silver, but with an epoxy resin or silicone resin which is commonly used as the sealing agent, the sealing performance is low, and it has been difficult to employ it for products which are required to have a reliability for a long period of time.

Accordingly, in order to prevent corrosion of a silver conductor layer, a method has been proposed to coat the surface of silver with a resin such as a silicone resin, an acrylic resin, an epoxy resin or an urethane resin (Patent Document 1).

However, even by such a coating of a resin, moisture or a corrosive gas is likely to enter into the resin or from the interface between the silver conductor layer and the resin, and as the time passes, the silver conductor layer is corroded, and thus such a method has a problem in the long-term reliability.

### PRIOR ART DOCUMENT

### PATENT DOCUMENT

Patent Document 1: JP 2007-67116 A

### DISCLOSURE OF INVENTION

### TECHNICAL PROBLEM

In order to solve the above problem, the present inventors have tried a method of covering a silver conductor layer on a substrate surface by using a glass film (Japanese Patent Application No. 2008-212591). However, glass has a low thermal conductivity and is thus poor in the heat dissipating properties of a heat generated by a LED, and such problems sometimes occur that when the amount of heat generation of the LED is large, the voltage applied to the LED tends to decrease, and the luminous efficiency thereby tends to decrease and the service life of the LED tends to be short.

An object of the present invention is to provide a light-emitting device having a high light reflectance while being less susceptible to deterioration of the reflectance due to corrosion, and having an improved light extraction efficiency.

Further, another object of the present invention is to suppress as far as possible the load on the process in the formation of such a light reflection layer.

### SOLUTION TO PROBLEM

In order to solve the above problems, the present invention provides the following. The invention corresponding to Claim 1 is a light-emitting device comprising a ceramic substrate having a built-in conductor layer for light reflection and provided with a hole so that a part of the conductor layer for light reflection is exposed, and a light-emitting element disposed on the ceramic substrate so as to be electrically connected through the hole, **characterized in that** an upper ceramic layer has a thickness of from 5 to 100 µm between the surface on which the light-emitting element is disposed and the conductor layer for light reflection.

The invention corresponding to Claim 2 is a light-emitting device comprising a ceramic substrate having a lower ceramic layer, a conductor layer for light reflection formed on a desired area of the lower ceramic layer surface and an upper ceramic layer formed so as to cover at least a part of the conductor layer for light reflection, and a light-emitting element disposed on the upper side of the upper ceramic layer of the ceramic substrate, **characterized in that** the upper ceramic layer has a thickness of from 5 to 100 µm.

The invention corresponding to Claim 3 is the light-emitting device corresponding to Claim 2, wherein an external electrode terminal is formed on the surface of the lower ceramic layer of the ceramic substrate on the opposite side to the light-emitting element, and the external electrode terminal and the conductor layer for light reflection are electrically connected to each other via a via conductor formed so as to pass through to the lower ceramic layer.

The invention corresponding to Claim 4 is the light-emitting device corresponding to any one of Claims 1 to 3, which has a sealing resin layer formed so as to enclose the light-emitting element and containing a phosphor which emits a visible light when excited by light radiated from the light-emitting element.

The invention corresponding to Claim 5 is the light-emitting device corresponding to any one of Claims 1 to 4, wherein the upper ceramic layer is white.

The invention corresponding to Claim 6 is the light-emitting device corresponding to any one of Claims 1 to 5, wherein the upper ceramic layer is composed of a glass-ceramics comprising, as represented by mass%, from 40 to 60% of a glass component and from 40 to 60% of a ceramic filler component.

The invention corresponding to Claim 7 is the light-emitting device corresponding to Claim 6, wherein the ceramic filler component is alumina.

The invention corresponding to Claim 8 is the light-emitting device corresponding to Claim 6 or 7, wherein the glass component is a glass comprising, as represented by mol% based on oxides, from 62 to 85% of SiO₂, from 5 to 25% of B₂O₃, from 0 to 5% of Al₂O₃ and from 0 to 5% in total of at least one of Na₂O and K₂O, provided that the total content of SiO₂ and Al₂O₃ is from 62 to 85%, and may contain at least one of MgO, CaO, SrO and BaO in a total content of at most 10%.

The invention corresponding to Claim 9 is the light-emitting device corresponding to any one of Claims 6 to 8, wherein the glass component comprises, as represented by mol% based on oxides, from 78 to 82% of SiO₂, from 16 to 18% of B₂O₃ and from 0.9 to 4% in total of at least one of Na₂O and K₂O.

The invention corresponding to Claim 10 is the light-emitting device corresponding to any one of Claims 1 to 9, wherein the upper ceramic layer is composed of a glass-ceramics having an elution amount of at most 100 µg/cm² when immersed in an oxalic acid solution with pH 1.68 at 85°C for 1 hour.

Further, the ceramic substrate for a light-emitting device of the present invention is a ceramic substrate for a light-emitting device having a conductor layer for light reflection to reflect a light of the light-emitting element, which comprises a lower ceramic layer, the conductor layer for light reflection located on the upper side of the lower ceramic layer and an upper ceramic layer located on the upper side of the conductor layer for light reflection and the upper side of the lower ceramic layer, wherein the upper ceramic layer located on the upper side of the conductor layer for light reflection has an open hole formed. And, the upper ceramic layer preferably has a thickness of from 5 to 100 µm.

The hole in the invention corresponding to Claim 1 means an open hole of the upper ceramic layer, which is formed so that a part of the built-in light reflective conductor layer in the ceramic substrate is exposed. A light-emitting element is disposed on the upper ceramic layer, and the light reflective conductor layer is electrically connected by a bonding wire connected to the light-emitting element through the hole.

The present inventors have let the ceramic substrate have a built-in conductor layer for light reflection in order to protect the conductor layer for light reflection, whereby a light-emitting device which is less susceptible to deterioration of the reflectance and excellent in heat dissipating properties can be obtained.

### ADVANTAGEOUS EFFECTS OF INVENTION

As the emitting device of the present invention has a conductor layer for light reflection having an extremely high light reflectance formed on the main surface of the substrate, the light from the light-emitting element radiated to the substrate side can be reflected at a high reflectance to the opening direction on the opposite side to the substrate. It is thereby possible to improve the light extraction efficiency thereby to improve the luminous efficiency.

Further, as the light-emitting device of the present invention has a phosphor layer which emits a visible light when excited by light from the light-emitting element, the visible light emitted from this phosphor is also reflected by the conductor layer for light reflection at a high reflectance to the forward direction on the opposite side to the substrate, whereby it is possible to improve the extraction efficiency of a white light formed by color mixing of the visible light emitted from the phosphor and the light radiated from the light-emitting element.

Further, as an upper ceramic layer composed of a glass-ceramics having a low light absorption is provided on the conductor layer for light reflection, the conductor layer for light reflection as a lower layer is chemically protected by this upper ceramic layer. Accordingly, corrosion of the conductor layer for light reflection is prevented, and deterioration of the light reflectance can be suppressed. Further, the upper ceramic layer has a high thermal conductivity and is thus less likely to impair the heat dissipation of a LED chip, whereby it is possible to prevent the decrease in the luminous efficiency and the shortage of the service life.

### BRIEF DESCRIPTION OF DRAWINGS

Fig. 1 is a cross-sectional view of a ceramic substrate having a built-in conductor layer for light reflection to be used in the present invention.
Fig. 2 is a cross-sectional view of a light-emitting device of the present invention.
Fig. 3 is a cross-sectional view of a light-emitting device of the present invention wherein the surface of the conductor layer for light reflection is plated.

### DESCRIPTION OF EMBODIMENTS

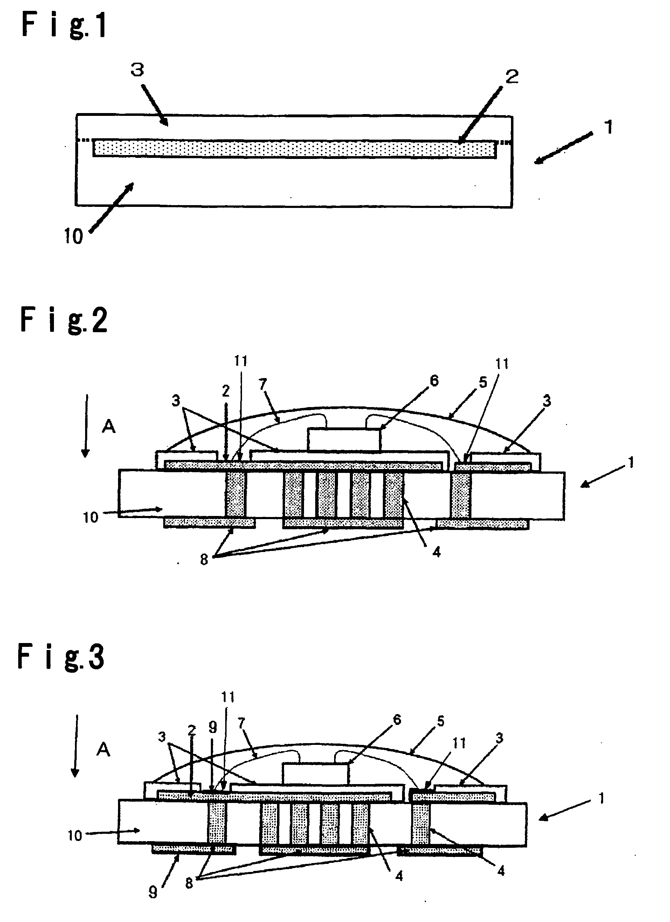

As shown in Figs. 2 and 3, a ceramic substrate 1 of the light-emitting device of the present invention comprises an upper ceramic layer 3, a conductor layer for light reflection 2 and a lower ceramic layer 10. And, a light-emitting element 6 is disposed on the upper side of the upper ceramic layer 3. An external electrode terminal 8 is formed on the surface of the lower ceramic layer 10 of the ceramic substrate 1 on the opposite side to the light-emitting element 6, and the external electrode terminal 8 and the conductor layer for light reflection 2 are electrically connected to each other via a via conductor 4 formed so as to pass through to the lower ceramic layer 10. The upper ceramic layer 3 has an open hole 11 formed at a desired position, and the light-emitting element 6 and the conductor layer for light reflection 2 are electrically connected via a bonding wire 7, which is connected through the open hole 11. In the Figures, 5 is a sealing resin layer formed so as to enclose the light-emitting element 6 and to cover a desired area of the upper ceramic layer 3 and the conductor layer for light reflection 2, and this sealing resin layer 5 contains a phosphor which emits a visible light when excited by light irradiated from the light-emitting element.

In the example shown in Fig. 3, a gold plating layer 9 is formed on the exposed surface of the conductor layer for light reflection 2, i.e. the surface of a desired area of the conductor layer for light reflection 2 which corresponds to the portion where the upper ceramic layer 3 is not formed and the open hole 11 of the upper ceramic layer 3 is formed, whereby characteristic degradation by color change of the conductor layer for light reflection 2 is prevented.

In the present invention, as the above conductor layer for light reflection, a particularly excellent one is a silver conductor, which functions as a conductor and is excellent in light reflectivity. Hereinafter, a conductor layer for light reflection will be sometimes referred to as a silver conductor layer. Now, the present invention will be described with a representative example of the present invention wherein such a silver conductor layer is employed.

The light-emitting device of the present invention has, as described above, a ceramic substrate (hereinafter sometimes referred to as the substrate of the present invention) having a built-in silver conductor layer, and a light-emitting element disposed on the substrate of the present invention so as to be electrically connected to the silver conductor layer. The substrate of the present invention comprises an upper ceramic layer, a conductor layer for light reflection and a lower ceramic layer.

The substrate of the present invention is a flat plate member on which a light-emitting element is to be mounted, and it is **characterized in that** it has a silver conductor layer to reflect a light from the light-emitting element toward the downward direction, i.e. a light toward the direction of arrow A in Figs. 2 and 3.

The upper ceramic layer of the substrate of the present invention is a layer to protect the silver conductor layer from e.g. corrosion, and it preferably contains a glass component and a ceramic filler component. It is typically a LTCC (low temperature co-fired ceramics) substrate. The upper ceramic layer of the substrate of the present invention contains a glass component and thus has a high sealing performance, whereby it is possible to protect the inner silver conductor layer sufficiently. Further, it contains a ceramic filler component and thus has a high thermal conductivity. Further, it has a thin thickness of at most 100 µm, and thus light reflected at the silver conductor layer is less likely to be absorbed, whereby it is possible to obtain a high reflectance.

In the substrate of the present invention, the material constituting the lower ceramic layer is not particularly limited as long as it is a ceramics on which a silver conductor etc. can be baked, but it is preferably the above described LTCC substrate from the viewpoint of thermal conductivity, heat dissipating properties, strength and cost. LTCC is a ceramics which is able to be co-fired with a silver conductor, and when both of the upper ceramic layer and the lower ceramic layer constituting the substrate of the present invention are made of LTCC, the substrate of the present invention wherein the upper ceramic layer, the lower ceramic layer and the silver conductor layer are integrated may be efficiently formed.

In the present invention, the light-emitting element is a LED element, and it may be one capable of emitting a visible light by exciting a phosphor by radiated light. For example, a blue light-emitting type LED chip or an ultraviolet light-emitting type LED chip may be exemplified. However, without being limited to such exemplified ones, various light-emitting elements may be used depending upon the particular applications or desired emission colors of the light-emitting devices.

Mounting of the light-emitting element is carried out, for example, by a method wherein a LED chip is bonded (die-bonded) on a substrate by an epoxy resin or a silicone resin, and an electrode on the surface of the chip is connected to a pad portion of the ceramic substrate via a bonding wire such as a gold wire, or by a method wherein a bump electrode such as a solder bump, an Au bump or an Au-Sn eutectic crystal bump provided on the rear side of a LED chip is connected to a lead terminal or a pad portion of the ceramic substrate by flip chip bonding.

The phosphor is excited by light radiated from the light-emitting element to emit a visible light, and by color mixing of this visible light and the light radiated from the light-emitting element, or by color mixing of the visible light emitted from the phosphor or visible light itself, a desired emission color as a light-emitting device is obtained. The type of the phosphor is not particularly limited and may suitably be selected depending upon the desired emission color, the light radiated from the light-emitting element, etc. The phosphor layer containing such a phosphor is formed by mixing and dispersing the phosphor in a transparent resin such as a silicone resin or an epoxy resin. The phosphor layer is formed so as to cover the outside of the light-emitting element.

Now, embodiments of the present invention will be described, but the present invention is by no means limited to such embodiments.

The lower ceramic layer of the substrate of the present invention is not particularly limited so long as a silver conductor layer and an upper ceramic layer (insulating layer) to protect it, can be provided thereon. However, in the following, a case where the substrate is a LTCC substrate will be described.

The LTCC substrate is a substrate which can be produced by co-firing together with the silver conductor layer. The LTCC substrate is produced usually by firing a glass powder and a ceramic filler powder which are formed into a green sheet. That is, firstly, to a glass powder and an aluminum powder, a resin such as polyvinylbutyral or an acrylic resin, a plasticizer such as dibutyl phthalate, dioctyl phthalate or butylbenzyl phthalate, a solvent such as toluene, xylene or butanol, a dispersant, and so on are added to obtain a slurry, and then this slurry is formed into a sheet by a doctor blade method or the like on a film of e.g. polyethylene terephthalate. The sheet-formed product is dried to remove the solvent thereby to obtain a green sheet. On such a green sheet, as the case requires, a wiring pattern, a via, etc. may be formed by e.g. screen printing using a silver paste, and usually, a plurality of the green sheets are laminated and fired.

The method to form the substrate of the present invention by using LTCC is not particularly limited, but a method wherein a silver conductor to be a silver conductor layer is printed with a silver paste on a green sheet to be a lower ceramic layer, and on the printed green sheet, another green sheet to be an upper ceramic layer is laminated followed by firing, a method wherein on a green sheet to be a lower ceramic layer, having a silver conductor printed, a glass-ceramic paste to be an upper ceramic layer is printed, followed by firing, and a method wherein a silver conductor is printed with a silver paste on a green sheet, followed by firing, and then a glass-ceramic paste to form an upper ceramic layer is printed, followed by firing, are mentioned.

The green sheet is processed into a desired shape and is fired to obtain a substrate. In such a case, one green sheet or a plurality of green sheets laminated are to be fired. Such firing is typically carried out by holding the green sheet(s) at from 850 to 900°C for from 20 to 60 minutes. The firing temperature is more typically from 860 to 880°C.

In the case of forming a silver conductor layer, the firing temperature is preferably at most 880°C. If the firing temperature exceeds 880°C, silver or the silver-containing conductor may be softened at the time of firing, whereby the shape of the conductor pattern may not be maintained. The firing temperature is more preferably at most 870°C.

The thickness of the upper ceramic layer is preferably from 5 to 100 µm. If it is less than 5 µm, when the light-emitting element is disposed thereon, the light-emitting element is likely to be inclined due to roughness of the surface of the silver conductor layer, whereby the light extraction efficiency is likely to be poor. If the thickness exceeds 100 µm, the heat dissipating properties of the light-emitting element are likely to be impaired, and the luminous efficiency is likely to be low, or the light will be absorbed and thus the reflectance will be decreased, whereby the light extraction efficiency is likely to be poor.

The upper ceramic layer of the substrate of the present invention is preferably composed of a glass-ceramics comprising a glass component and a ceramic filler component. Their ratio is such that the ceramic filler component is from 40 to 60 mass%, and the rest is the glass component. The glass-ceramics having the glass of the present invention which will be hereinafter described and the ceramic filler component in this ratio will be hereinafter referred to as a first glass-ceramics.

The ceramic filler is mixed for the purpose of improving the thermal conduction, and it is preferably made of a material having a high thermal conductivity and a low light absorption in the visible light range. Typically, alumina is used. The mixed amount of the ceramic filler component is from 40 to 60 mass% in 100% of the total amount of the glass component and the ceramic filler component. If it is less than 40%, the conductivity will not be increased, and the effect on heat dissipating properties will be small. If it exceeds 60%, the sinterability will be inhibited, and the protection of the silver conductor layer will possibly be insufficient.

The upper ceramic layer of the substrate of the present invention preferably has a small light absorption, and it is preferably white in color.

The upper ceramic layer of the substrate of the present invention is formed, for example, forming the first glass-ceramics into a paste and screen-printing it, followed by firing. Or, it is formed by forming the first glass-ceramics into a green sheet, followed by firing. However, the forming method is not particularly limited so long as it is typically a method capable of forming one having a thickness of from 5 to 100 µm to be planer.

The glass component contained in the first glass-ceramics is preferably a glass (hereinafter referred to as the glass of the present invention) comprising, as represented by mol% based on oxides, from 62 to 85% of SiO₂, from 5 to 25% of B₂O₃, from 0 to 5% of Al₂O₃ and from 0 to 5% in total of at least one of Na₂O and K₂O provided that the total content of SiO₂ and Al₂O₃ is from 62 to 85%, and may contain at least one of MgO, CaO, SrO and BaO in a total content of at most 10%.

The glass of the present invention may be obtained by a melting method, and it is ground to obtain a glass powder. The grinding method is not particularly limited so long as the object of the present invention is not impaired, and either wet grinding or dry grinding may suitably be adopted. In the case of wet grinding, it is preferred to use water as a solvent. Further, for grinding, a grinding machine such as a roll mill, a ball mill or a jet mill may suitably be used. The glass after grinding is dried as the case requires, and classified.

The particle size, shape, etc. of alumina are not particularly limited. Typically, however, one having an average particle size D₅₀ of from 1 to 5 µm is used. As such alumina, for example, AL-47H manufactured by Showa Denko K.K. may be mentioned. The average particle size D₅₀ in this description means one measured by using a laser diffraction/scattering particle size distribution measuring apparatus.

The conductor layer for light reflection is preferably composed of a silver conductor or a silver alloy conductor. The material other than the silver conductor may, for example, be a silver-palladium alloy or a silver-platinum alloy. It preferably contains no other inorganic component from the viewpoint of improving the reflectance of the conductor layer for light reflection.

When the lower ceramic layer of the substrate of the present invention is composed of LTCC, the second glass-ceramics constituting the lower ceramic layer and the first glass-ceramics constituting the upper ceramic layer may have the same composition.

Further, the glass of the present invention may suitably be used as a glass selected as a glass to form the lower ceramic layer. For the purpose of improving the strength of the LTCC substrate, the glass used for the second glass-ceramics constituting the lower ceramic layer preferably comprises, for example, as represented by mol%, from 57 to 65% of SiO₂, from 13 to 18% of B₂O₃, from 3 to 8% of Al₂O₃, from 9 to 23% of CaO and from 0.5 to 6% of at least one of K₂O and Na₂O. Further, the ceramic filler is typically alumina.

In such a case, the blend ratio of the glass powder and the alumina powder is typically 40 mass% of the glass powder and 60 mass% of the alumina filler.

Now, the glass of the present invention will be described. In the following, unless otherwise specified, the composition is shown by mol%, which is represented simply by %.

SiO₂ is a glass network former and is essential. If it is less than 62%, silver coloring is likely to occur, and the reflectance of the substrate may possibly be decreased. It is preferably at least 64%, more preferably at least 74%. If it exceeds 85%, the glass melting temperature tends to be high, or the glass transition point (Ts) tens to be high, and thus the temperature required for firing sometimes becomes high. It is preferably at most 84%, more preferably at most 82%.

B₂O₃ is a glass network former and is essential. If it is less than 5%, the glass melting temperature tends to be high, or Ts tends to be too high. It is preferably at least 10%, more preferably at least 12%. If it exceeds 25%, it becomes difficult to obtain a stable glass, or the chemical durability may deteriorate. It is preferably at most 22%, more preferably at most 18%.

Al₂O₃ is not essential, but it may be contained within a range of at most 5% in order to increase the stability or chemical durability of the glass. If it exceeds 5%, coloring of yellow (silver coloring) is likely to occur when it is fired on the silver conductor. It is preferably at most 1%, more preferably at most 0.5%.

Further, the total content of SiO₂ and Al₂O₃ is from 62 to 85%. If it is less than 62%, the chemical durability is likely to be inadequate. It is preferably at least 64%, more preferably at least 74%. If it exceeds 85%, the glass melting temperature tends to be high, or Ts tends to be too high, and thus firing at a low temperature tends to become difficult. It is preferably at most 84%, more preferably at most 82%.

Na₂O and K₂O are not essential, but they are components to lower Ts, and they may be contained in a total amount of up to 5%. If the total amount exceeds 5%, the chemical durability, particularly the acid resistance is likely to deteriorate, or the electrical insulating properties of a fired product are likely to be low. The total amount is preferably at most 4%, more preferably at most 3%. Further, the total amount is preferably at least 0.9%.

Any one of MgO, CaO, SrO and BaO is not essential, but they may be contained up to 10% in total in order to lower Ts or to stabilize the glass. If the total amount exceeds 10%, silver coloring is likely to occur. The total amount is preferably at most 7%, more preferably at most 5%.

The glass of the present invention essentially comprises the above components, but may contain other components within a range not to impair the object of the present invention. In a case where such other components are contained, the total content of such components is preferably at most 10%. However, no lead oxide is contained.

In order to make the acid resistance of the upper ceramic layer higher, the glass of the present invention is preferably a glass (hereinafter referred to as glass A of the present invention) comprising from 78 to 82% of SiO₂, from 16 to 18% of B₂O₃ and from 0.9 to 4% in total of at least one of Na₂O and K₂O and containing at most 0.5% of Al₂O₃ and at most 1% of CaO.

Now, the composition of glass A of the present invention will be described. Glass A of the present invention is the glass of the present invention, and it is a preferred glass particularly when it is desired that the reflecting performance of the conductor layer for light reflection will not be impaired by the upper ceramic layer so as to make the reflectance high.

SiO₂ is a glass network former and is essential. If it is less than 78%, the chemical durability tends to be low. It is preferably at least 80%. If it exceeds 82%, the glass melting temperature tends to be high, or Ts tends to be too high.

B₂O₃ is a glass network former and is essential. If it is less than 16%, the glass melting temperature tends to be high, or Ts tends to be too high, and if it exceeds 18%, stable glass tends to be hardly obtainable, or the chemical durability tends to be low. It is preferably at most 17%.

Al₂O₃ is not essential, but may be contained within a range of at most 0.5% in order to increase the stability or chemical durability of the glass. If it exceeds 0.5%, the glass melting temperature tends to be high, or Ts tends to be too high.

Na₂O and K₂O are components to lower Ts, and it is preferred that at least one of them is contained. If the total amount is less than 0.9%, the glass melting temperature tends to be high, or Ts tends to be too high, and it is preferably at least 1.0%, more preferably at least 1.5%. If it exceeds 4%, the chemical durability, particularly the acid resistance tends to be deteriorate, or the electrical insulating property of the fired product tends to be low. It is preferably at most 3%, more preferably at most 2%.

CaO is not essential, but may be contained within a range of at most 1% in order to lower Ts or to stabilize the glass. If it exceeds 1%, the glass melting temperature tends to be low, or the crystallization tends to be accelerated, whereby a clear glass layer tends to be hardly obtainable. It is preferably at most 0.6%.

Glass A of the present invention essentially comprises the above components, but may contain other components within a range not to impair the purpose of the present invention. In a case where such other components are contained, their total content is preferably at most 10%. However, no lead oxide is contained.

### EXAMPLES

A green sheet for forming a lower ceramic layer is prepared by the following method. That is, a glass raw material was blended and mixed to obtain a composition comprising, as represented by mol%, 60.4% of SiO₂, 15.6% of B₂O₃, 6% of Al₂O₃, 15% of CaO, 1% of K₂O and 2% of Na₂O, and the mixed raw material was put in a platinum crucible and melted at from 1,550 to 1,600°C for 60 minutes, and then the molten glass was cast and cooled. The obtained glass was ground in ethyl alcohol by a ball mill made of alumina for from 20 to 60 hours to obtain a glass powder. D₅₀ of the powder was measured by SALD21 00 manufactured by Shimadzu Corporation, and was found to be 2.5 µm. The softening point Ts (unit: °C) and the crystallization peak temperature Tc (unit: °C) were measured by a thermal analysis equipment TG-DTA2000 manufactured by BrukerAXS K.K. up to 1,000°C under a temperature raising rate of 10°C/min, and Ts was unclear and Tc was found to be 850°C.

50 g of a powder obtained by mixing, as represented by mass%, 40% of the above glass powder and 60% of an alumina powder AL-45H manufactured by Showa Denko K.K. was mixed with 15 g of an organic solvent (a mixture of toluene, xylene, 2-propanol and 2-butanol in a mass ratio of 4:2:2:1), 2.5 g of a plasticizer (di-2-ethylhexyl phthalate), 5 g of a resin (polyvinyl butyral, PVK #3000K manufactured by DENKA) and a dispersant (DISPERBYK180 manufactured by BYK-Chemie) to obtain a slurry. This slurry was applied on a PET film by a doctor blade method, followed by drying to obtain a green sheet having a thickness of 0.2 mm for forming a lower ceramic layer. In Examples 1 to 18, the lower ceramic layer was formed by using this green sheet.

### EXAMPLES 1 to 18

A glass-ceramic paste for forming an upper ceramic layer was prepared by the following method. That is, in each Example, raw materials were blended and mixed to obtain a composition shown in the fields for SiO₂ to ZrO₂ as represented by mol% in Tables 1 to 3, and the mixed raw materials were put in a platinum crucible and melted at from 1,550 to 1,600°C for 60 minutes, and then the molten glass was cast and cooled. The obtained glass was ground in ethyl alcohol by a ball mill made of alumina for from 20 to 60 hours to obtain a glass powder in the same method as above. D₅₀ (unit: µm) of each obtained glass powder was measured by SALD21 00 manufactured by Shimadzu Corporation. Further, the softening point Ts (unit: °C) and the crystallization peak temperature Tc (unit: °C) were measured by a thermal analysis equipment TG-DTA2000 manufactured by BrukerAXS K.K. up to 1,000°C under a temperature raising rate of 10°C/min. The measured values of D₅₀ (unit: µm), the softening point Ts (unit: °C) and the crystallization peak temperature Tc (unit: °C) of each glass powder having respective composition are shown in Tables 1 to 3. The description "Unclear" in the fields for Ts indicates that the inflection point representing Ts was unclear. The symbol "∞" in the fields for Tc indicates that no crystalline peak was observed until the temperature became 1,000°C.

Each glass powder was mixed with the alumina powder AL-45H to obtain a glass-ceramics mixed powder having the alumina powder content shown as represented by mass% in the fields for "Filler amount" in the Tables 1 to 3. One comprising, as represented by mass%, 60% of each mixed powder and 40% of an organic vehicle having ethyl cellulose and α-terpineol mixed in a mass ratio of 85:15 was mixed for 1 hour in a porcelain mortar, and further was dispersed three times by a three-roll mill to obtain a glass-ceramics paste. Examples 1 to 11 are examples of the glass-ceramics of the present invention. Examples 1 to 7 are examples of the glass-ceramics of the present invention using the glass of the present invention.

### (Preparation of ceramic substrate and evaluation thereof)

A silver powder (S400-2 manufactured by DAIKEN CHEMICAL CO., LTD.) and the above organic vehicle were blended in a mass ratio of 85:15, followed by mixing for 1 hour in a porcelain mortar and further by dispersion by a three-roll mill to obtain a silver paste.

The above silver paste was printed on laminated six green sheets for forming a lower ceramic layer, followed by drying, and then the glass-ceramic paste for forming an upper ceramic layer in each of Examples 1 to 18 was printed on the silver paste, and the printed product was held at 550°C for 5 hours to burn out the resin component and then held at 870°C for 30 minutes to carry out firing to obtain a ceramic substrate (LTCC substrate) 1 having a lower ceramic layer 10, a silver conductor layer 2 and an upper ceramic layer laminated and having the silver conductor layer 2 including its edge portion built-in, as shown in Fig. 1.

The reflectance of the main surface of each LTCC substrate 1 was measured by using a spectrometer USB2000 and a small sized integrated sphere ISP-RF manufactured by Ocean Optics, and an average value in the visible light region of from 400 to 800 nm was calculated as the reflectance (unit: %). The results are shown in Tables 1 to 3. The reflectance is preferably at least 90%, and the higher reflectance is more preferred.

Further, the acid resistance of the upper ceramic layer was evaluated by the following method. That is, 4 g of the above glass-ceramics mixed powder was pressed by a mold and fired to obtain a sintered product having a diameter of about 14 mm and a height of about 1.5 cm. Then, the sintered product was immersed in 700 cm³ of an oxalic acid buffer solution with a pH 1.68 at a temperature of 85°C, and the mass reduction after expiration of 1 hour was measured. Here, the mass after the immersion was measured after drying at 100°C for 1 hour. The mass reduction per unit surface area of the sintered product (unit: ug/cm²) is shown in each field for "Acid resistance" in Tables 1 to 3. The acid resistance is preferably at most 100 µg/cm², more preferably at most 30 µg/cm². If it exceeds 100 µg/cm², components in the glass are likely to elute into the plating solution, whereby a continuous operation may not be carried out, or the upper ceramic layer is likely to be corroded, whereby absorption of light may be increased.

The heat dissipation property was measured by using a thermal resistance measuring instrument manufactured by Minekoon Denki K.K. (model: TH-2167). Four LED chips GQ2CR460Z manufactured by Showa Denko K.K. were connected in series, and as a die bonding agent, KER-3000-M2 manufactured by Shin-Etsu Chemical Co., Ltd. was used. As a sealing agent, SCR-1016A manufactured by Shin-Etsu Chemical Co., Ltd. was used. The applied current was set to be 35 mA, the current was applied until the time when voltage drop became saturated, and the saturation temperature Tj (°C) was calculated from the dropped voltage and the temperature coefficient derived from temperature-voltage drop characteristic of the LED chip. The saturation temperature is preferably lower than 50°C, more preferably at most 45°C. If it is higher than 50°C, the voltage drop is likely to be large, whereby the light extraction efficiency of the LED chip may become poor, or the service life may become short.

**TABLE 1**

| Ex. | 1 | 2 | 3 | 4 | 5 | 6 | 7 |
|---|---|---|---|---|---|---|---|
| SiO₂ | 81.6 | 81.6 | 78 | 81.6 | 80.7 | 80 | 85 |
| B₂O₃ | 16.6 | 16.6 | 18 | 16.6 | 16.6 | 13 | 5 |
| Al₂O₃ | 0 | 0 | 0 | 0 | 0.3 | 0 | 0 |
| CaO | 0 | 0 | 0 | 0 | 0.6 | 3 | 6 |
| SrO | 0 | 0 | 0 | 0 | 0 | 0 | 0 |
| BaO | 0 | 0 | 0 | 0 | 0 | 0 | 0 |
| MgO | 0 | 0 | 0 | 0 | 0 | 0 | 0 |
| Li₂O | 0 | 0 | 0 | 0 | 0 | 0 | 0 |
| K₂O | 1.8 | 1.8 | 4 | 0.9 | 0.9 | 4 | 4 |
| Na₂O | 0 | 0 | 0 | 0.9 | 0.9 | 0 | 0 |
| ZrO₂ | 0 | 0 | 0 | 0 | 0 | 0 | 0 |
| D₅₀ | 2.5 | 2.5 | 2.5 | 2.5 | 2.5 | 2.5 | 2.5 |
| Ts | 775 | 775 | 760 | 776 | 780 | Unclear | Unclear |
| Tc | ∞ | ∞ | ∞ | ∞ | ∞ | ∞ | ∞ |
| Filler amount | 50 | 60 | 60 | 60 | 60 | 50 | 50 |
| Reflectance | 91 | 90 | 90 | 90 | 90 | 82 | 80 |
| Acid resistance | 0 | 0 | 0 | 0 | 2 | 1 | 3 |
| Saturation temperature | 47 | 42 | 45 | 45 | 46 | 46 | 45 |

**TABLE 2**

| Ex. | 8 | 9 | 10 | 11 | 12 | 13 | 14 |
|---|---|---|---|---|---|---|---|
| SiO₂ | 60.4 | 60.4 | 63.2 | 63.2 | 81.6 | 81.6 | 78 |
| B₂O₃ | 15.6 | 15.6 | 7.6 | 7.6 | 16.6 | 16.6 | 18 |
| Al₂O₃ | 6 | 6 | 11.3 | 11.3 | 0 | 0 | 0 |
| CaO | 13 | 13 | 4.7 | 4.7 | 0 | 0 | 0 |
| SrO | 0 | 0 | 4.9 | 4.9 | 0 | 0 | 0 |
| BaO | 0 | 0 | 2 | 2 | 0 | 0 | 0 |
| MgO | 0 | 0 | 5.3 | 5.3 | 0 | 0 | 0 |
| Li₂O | 0 | 0 | 1 | 0 | 0 | 0 | 0 |
| K₂O | 1 | 1 | 0 | 1 | 1.8 | 1.8 | 4 |
| Na₂O | 2 | 2 | 0 | 0 | 0 | 0 | 0 |
| ZrO₂ | 2 | 2 | 0 | 0 | 0 | 0 | 0 |
| D₅₀ | 2.5 | 2.5 | 2.5 | 2.5 | 2.5 | 2.5 | 2.5 |
| Ts | 856 | 856 | 751 | 750 | 775 | 775 | 760 |
| Tc | ∞ | ∞ | ∞ | ∞ | ∞ | ∞ | ∞ |
| Filler amount | 50 | 60 | 50 | 50 | 5 | 30 | 0 |
| Reflectance | 74 | 73 | 76 | 76 | 94 | 92 | 94 |
| Acid resistance | 3 | 2 | 8 | 7 | 0 | 0 | 0 |
| Saturation temperature | 45 | 44 | 47 | 46 | 53 | 50 | 56 |

**TABLE 3**

| Ex. | 15 | 16 | 17 | 18 |
|---|---|---|---|---|
| SiO₂ | 80 | 85 | 60.4 | 81.6 |
| B₂O₃ | 13 | 5 | 15.6 | 16.6 |
| Al₂O₃ | 0 | 0 | 6 | 0 |
| CaO | 3 | 6 | 13 | 0 |
| SrO | 0 | 0 | 0 | 0 |
| BaO | 0 | 0 | 0 | 0 |
| MgO | 0 | 0 | 0 | 0 |
| Li₂O | 0 | 0 | 0 | 0 |
| K₂O | 4 | 4 | 1 | 1.8 |
| Na₂O | 0 | 0 | 2 | 0 |
| ZrO₂ | 0 | 0 | 2 | 0 |
| D₅₀ | 2.5 | 2.5 | 2.5 | 2.5 |
| Ts | Unclear | Unclear | 856 | 775 |
| Tc | ∞ | ∞ | ∞ | ∞ |
| Filler amount | 0 | 0 | 10 | 70 |
| Reflectance | 88 | 86 | 77 | 80 |
| Acid resistance | 2 | 7 | 6 | 85 |
| Saturation temperature | 56 | 56 | 53 | 53 |

### INDUSTRIAL APPLICABILITY

According to the present invention, a light-emitting device having a high light reflectance and being less susceptible to deterioration of the reflectance due to corrosion, and having an improved light extraction efficiency. Such a light-emitting device may suitably be used for a backlight of e.g. a mobile phone or a large sized liquid crystal TV, and various lightening equipments.

The entire disclosure of Japanese Patent Application No. 2009-148577 filed on June 23, 2009 including specification, claims, drawings and summary is incorporated herein by reference in its entirety.

### REFERENCE SYMBOLS

- 1:: Ceramic substrate (LTCC substrate)
- 2:: Conductor layer for light reflection (silver conductor layer, conductor layer)
- 3:: Upper ceramic layer
- 4:: Via conductor
- 5:: Sealing resin layer (containing a phosphor)
- 6:: Light-emitting element
- 7:: Bonding wire
- 8:: External electrode terminal
- 9:: Gold plating
- 10:: Lower ceramic layer
- 11:: Open hole

## Claims

1. A light-emitting device comprising a ceramic substrate having a built-in conductor layer for light reflection and provided with a hole so that a part of the conductor layer for light reflection is exposed, and a light-emitting element disposed on the ceramic substrate so as to be electrically connected through the hole, **characterized in that** an upper ceramic layer has a thickness of from 5 to 100 µm between the surface on which the light-emitting element is disposed and the conductor layer for light reflection.

2. A light-emitting device comprising a ceramic substrate having a lower ceramic layer, a conductor layer for light reflection formed on a desired area of the lower ceramic layer surface and an upper ceramic layer formed so as to cover at least a part of the conductor layer for light reflection, and a light-emitting element disposed on the upper side of the upper ceramic layer of the ceramic substrate, **characterized in that** the upper ceramic layer has a thickness of from 5 to 100 µm.

3. The light-emitting device according to Claim 2, wherein an external electrode terminal is formed on the surface of the lower ceramic layer of the ceramic substrate on the opposite side to the light-emitting element, and the external electrode terminal and the conductor layer for light reflection are electrically connected to each other via a via conductor formed so as to pass through to the lower ceramic layer.

4. The light-emitting device according to any one of Claims 1 to 3, which has a sealing resin layer formed so as to enclose the light-emitting element and containing a phosphor which emits a visible light when excited by a light radiated from the light-emitting element.

5. The light-emitting device according to any one of Claims 1 to 4, wherein the upper ceramic layer is white.

6. The light-emitting device according to any one of Claims 1 to 5, wherein the upper ceramic layer is composed of a glass-ceramics comprising, as represented by mass%, from 40 to 60% of a glass component and from 40 to 60% of a ceramic filler component.

7. The light-emitting device according to Claim 6, wherein the ceramic filler component is alumina.

8. The light-emitting device according to Claim 6 or 7, wherein the glass component is a glass comprising, as represented by mol% based on oxides, from 62 to 85% of SiO₂, from 5 to 25% of B₂O₃, from 0 to 5% of Al₂O₃ and from 0 to 5% in total of at least one of Na₂O and K₂O, provided that the total content of SiO₂ and Al₂O₃ is from 62 to 85%, and may contain at least one of MgO, CaO, SrO and BaO in a total content of at most 10%.

9. The light-emitting device according to any one of Claims 6 to 8, wherein the glass component comprises, as represented by mol% based on oxides, from 78 to 82% of SiO₂, from 16 to 18% of B₂O₃ and from 0.9 to 4% in total of at least one of Na₂O and K₂O.

10. The light-emitting device according to any one of Claims 1 to 9, wherein the upper ceramic layer is composed of a glass-ceramics having an elution amount of at most 100 µg/cm² when immersed in an oxalic acid solution with pH 1.68 at 85°C for 1 hour.

11. A ceramic substrate for a light-emitting device having a conductor layer for light reflection to reflect a light of the light-emitting element, which comprises a lower ceramic layer, the conductor layer for light reflection located on the upper side of the lower ceramic layer and an upper ceramic layer located on the upper side of the conductor layer for light reflection and the upper side of the lower ceramic layer, wherein the upper ceramic layer located on the upper side of the conductor layer for light reflection has an open hole formed.

12. The ceramic substrate for a light-emitting device according to Claim 11, wherein the upper ceramic layer has a thickness of from 5 to 100 µm.

13. The ceramic substrate for a light-emitting device according to Claim 11 or 12, wherein the upper ceramic layer and the lower ceramic layer are composed of a glass-ceramics comprising, as represented by mass%, from 40 to 60% of a glass component and from 40 to 60% of a ceramic filler component.

14. The ceramic substrate for a light-emitting device according to Claim 13, wherein the glass component is a glass comprising, as represented by mol% based on oxides, from 62 to 85% of SiO₂, from 5 to 25% of B₂O₃, from 0 to 5% of Al₂O₃, and from 0 to 5% in total of at least one of Na₂O and K₂O, provided that the total content of SiO₂ and Al₂O₃ is from 62 to 85, and may contain at least one of MgO, CaO, SrO and BaO in a total content of at most 10%.
